Europäisches Patentamt

European Patent Office

Office européen des brevets

(19)

(11) **EP 0 917 293 A1**

(12) ## DEMANDE DE BREVET EUROPEEN

(43) Date de publication:
    **19.05.1999 Bulletin 1999/20**

(51) Int Cl.$^6$: **H03M 11/24**

(21) Numéro de dépôt: **98203713.7**

(22) Date de dépôt: **03.11.1998**

(84) Etats contractants désignés:
    **AT BE CH CY DE DK ES FI FR GB GR IE IT LI LU MC NL PT SE**
    Etats d'extension désignés:
    **AL LT LV MK RO SI**

(30) Priorité: **13.11.1997 FR 9714245**

(71) Demandeur: **Koninklijke Philips Electronics N.V.**
    **5621 BA Eindhoven (NL)**

(72) Inventeurs:
    • **De Crouy-Chanel, Rémy**
      **75008 Paris (FR)**
    • **Boursier, Alain**
      **75008 Paris (FR)**

(74) Mandataire: **Chaffraix, Jean**
    **Société Civile S.P.I.D.**
    **156, Boulevard Haussmann**
    **75008 Paris (FR)**

(54) **Appareil comportant un clavier et clavier permettant de détecter l'appui simultané de deux touches**

(57)    Cet appareil comporte un clavier formé d'une pluralité de touches (K1...K7) à chacune desquelles est affecté au moins un contact électrique (I1...I7) et d'un dispositif pour permettre de détecter l'appui simultané de touches. Ce dispositif est muni :

-   d'une chaîne de résistances (R1...R6) interconnectant lesdits contacts (I1...I7),
-   de générateurs de grandeurs électriques (15, 16) pour alimenter en une première grandeur électrique les extrémités de ladite chaîne,
-   de mesureurs d'une deuxième grandeur électrique (18, 19) placés à proximité desdites extrémités et
-   d'un analyseur de mesure (25) pour déterminer les touches appuyées en fonction des indications fournies par lesdits mesureurs.

Application : clavier pour téléphones cellulaires

FIG.2

EP 0 917 293 A1

## Description

L'invention concerne un appareil comportant un clavier formé d'une pluralité de touches à chacune desquelles est affecté au moins un contact électrique et d'un dispositif permettant de détecter l'appui simultané de touches.

L'invention concerne aussi un tel clavier.

L'invention trouve des applications importantes dans tous les appareils qui nécessitent un clavier. Par exemple, des calculettes, des appareils téléphoniques etc..

Le brevet des Etats-Unis d'Amérique n° US 5 371 498 décrit un clavier qui permet de détecter l'appui simultané de touches. La détermination des touches est basée sur des valeurs différentes de résistances affectées chacune à une touche. Ceci constitue un premier inconvénient pour la fabrication d'un tel clavier. Un deuxième inconvénient est dû à la présence d'un ensemble de diodes dont le nombre est égal à celui des touches ce qui complique encore plus la fabrication.

L'invention propose un appareil du genre mentionné dans le préambule pour lequel la structure du clavier est particulièrement économique à fabriquer et à utiliser.

Pour cela, un tel appareil est remarquable en ce que ledit dispositif est muni :

- d'une chaîne de résistances interconnectant lesdits contacts,
- de générateurs de grandeurs électriques pour alimenter en une première grandeur électrique les extrémités de ladite chaîne,
- de mesureurs d'une deuxième grandeur électrique placés à proximité desdites extrémités et
- d'un analyseur de mesure pour déterminer les touches appuyées en fonction des indications fournies par lesdits mesureurs.

Ainsi, par une mesure de grandeur électrique effectuée à chaque extrémité de la chaîne, on détermine facilement les touches appuyées.

La description suivante faite en regard des dessins ci-annexés, le tout donné à titre d'exemple non limitatif, fera bien comprendre comment l'invention peut être réalisée.

La figure 1 montre un appareil téléphonique, vu de face, conforme à l'invention.

La figure 2 montre le schéma électrique d'un clavier conforme à l'invention.

La figure 3 montre un autre schéma électrique d'un clavier conforme à l'invention, obtenu par dualité avec le premier.

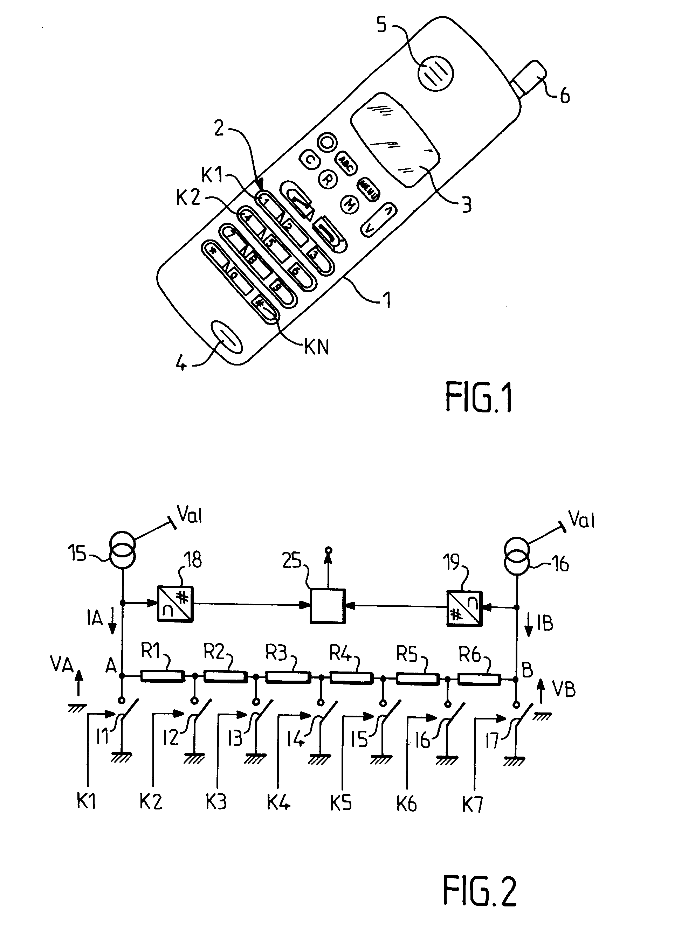

A la figure 1, l'appareil représenté est un appareil téléphonique utilisé, par exemple, pour un système GSM. Il va de soi que l'invention se rapporte à toutes sortes d'appareils électriques. L'appareil de la figure 1 se compose d'un boîtier 1 présentant une face avant sur laquelle sont disposés un clavier 2 formé d'une pluralité de touches K1, K2,....KN, un écran 3, un microphone 4 et un écouteur 5. Cet appareil comporte également une antenne 6.

Comme on essaye de minimiser le nombre de touches, il s'est avéré important de pouvoir décoder des appuis simultanés de touches. Pour cela, on a prévu un dispositif montré à la figure 2.

Sur cette figure 2, on a prévu 7 touches seulement pour ne pas surcharger les figures. Ces sept touches portant les références K1, K2,.....K7 agissent sur des contacts I1, I2,..., I7 respectivement. Une chaîne de résistances R1 à R6 interconnecte une première extrémité de ces contacts I1 à I7, l'autre extrémité de ces résistances étant reliée à la masse. Cette chaîne est alimentée par des générateurs de courant 15 et 16 fournissant respectivement un courant IA et IB. A chacune de ces extrémités on a affecté un mesureur de tension sous la forme d'un codeur numérique-analogique 18 et 19. Un circuit de sortie 25 fournit l'identification des touches appuyées, en analysant les informations fournies par les deux convertisseurs 18 et 19.

Ce circuit est déterminé par les considérations suivantes. Pour faciliter les explications on donne différentes valeurs :

$$IA = IB = 10 \ \mu A$$

$$R1 = R2 = ... = 10k\Omega$$

Le tableau ci-dessous donne les valeurs, en volts, aux points A et B, en fonction des touches appuyées.

| Touche | A | B |
|--------|-----|-----|
| K1 | 0,0 | 0,6 |
| K2 | 0,1 | 0,5 |
| K3 | 0,2 | 0,4 |
| K4 | 0,3 | 0,3 |
| K5 | 0,4 | 0,2 |
| K6 | 0,5 | 0,1 |
| K7 | 0,6 | 0,0 |
| NO | Val | Val |

NO signifie qu'aucune touche n'est appuyée. La tension "Val" volt aux points A et B est la tension d'alimentation appliquée aux générateurs de courant qui sont constitués généralement par le circuit collecteur de transistor. Lorsque que le collecteur n'est relié à aucune source, il se trouve porté à la tension d'alimentation "Val".

Ainsi la tension VA, VB, mesurée aux points A et B, permet de déterminer, au plus, deux touches appuyées en même temps.

Par exemple, si VA = 0,2 volt et VB = 0,4 volt seule la touche K3 a été appuyée ; si VA = 0,5 volt et VB = 0,6 volt alors les touches K6 et K1 sont simultanément appuyées.

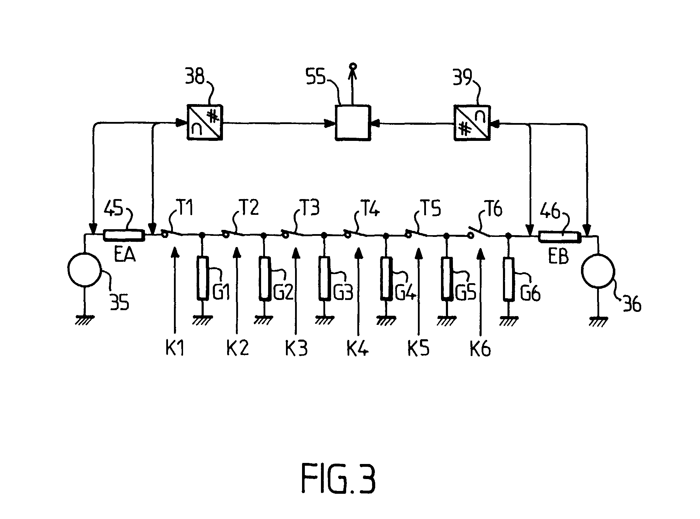

Du montage représenté à la figure 2, on peut déduire de la dualité tension-courant, le montage de la figure 3.

Ce montage est constitué aussi par une chaîne de résistances G1 à G6 placées en parallèle avec une extrémité à la masse et dont les autres extrémités sont reliées entre elles par l'intermédiaire de contacts T1 à T6 mis en position ouverte sous l'action respective des touches K1 à K6. Cette chaîne est alimentée de chaque côté par des générateurs de tension 35 et 36 fournissant respectivement des tensions EA et EB. Des résistances, 45, 46, de valeur relativement réduite permettent de mesurer le courant débité par ces générateurs. Deux convertisseurs analogiques-numériques 38 et 39 donnent la valeur du courant débité. Un circuit de sortie 55 fournit l'information de touches appuyées.

Il va de soi que pour ces deux modes de réalisation, on peut les alimenter par des générateurs de tension ou de courant au détriment de la linéarité des mesures.

**Revendications**

1. Appareil comportant un clavier formé d'une pluralité de touches à chacune desquelles est affecté au moins un contact électrique et d'un dispositif pour permettre de détecter l'appui simultané de touches, caractérisé en ce que ledit dispositif est muni :

   - d'une chaîne de résistances interconnectant lesdits contacts,
   - de générateurs de grandeurs électriques pour alimenter en une première grandeur électrique les extrémités de ladite chaîne,
   - de mesureurs d'une deuxième grandeur électrique placés à proximité desdites extrémités et
   - d'un analyseur de mesure pour déterminer les touches appuyées en fonction des indications fournies par lesdits mesureurs.

2. Appareil électrique selon la revendication 1, caractérisé en ce que lesdits générateurs de première grandeur électrique sont des générateurs de courant tandis que lesdites résistances sont placées en série et les contacts en parallèle.

3. Appareil électrique selon la revendication 1, caractérisé en ce que lesdits générateurs de première grandeur électrique sont des générateurs de tension tandis que lesdites résistances sont placées en parallèle et les contacts en série.

4. Clavier formé d'une pluralité de touches à chacune desquelles est affecté au moins un contact électrique et d'un dispositif pour détecter l'appui simultané de touches, caractérisé en ce que ledit dispositif est muni :

   - d'une chaîne de résistances interconnectant lesdits contacts,
   - de générateurs de grandeurs électriques pour alimenter en une première grandeur électrique les extrémités de ladite chaîne,
   - de mesureurs d'une deuxième grandeur électrique placés à proximité desdites extrémités et
   - d'un analyseur de mesure pour déterminer les touches appuyées en fonction des indications fournies par lesdits mesureurs.

5. Clavier selon la revendication 4, caractérisé en ce que lesdits générateurs de première grandeur électrique sont des générateurs de courant tandis que lesdites résistances sont placées en série et les contacts en parallèle.

6. Clavier selon la revendication 4, caractérisé en ce que lesdits générateurs de première grandeur électrique sont des générateurs de tension tandis que lesdites résistances sont placées en parallèle et les contacts en série.

FIG.1

FIG.2

FIG.3

**Office européen des brevets**

## RAPPORT DE RECHERCHE EUROPEENNE

Numéro de la demande

EP 98 20 3713

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | EP 0 264 884 A (MATSUSHITA ELECTRIC IND CO LTD) 27 avril 1988<br>* page 5, ligne 20 - ligne 28; figure 8 *<br>--- | 1,4 | H03M11/24 |
| A | FR 2 653 279 A (JAEGER) 19 avril 1991<br>* page 2, ligne 5 - page 3, ligne 12; figure 1 *<br>* page 9, ligne 6 - ligne 25; figure 4 *<br>--- | 1,4 | |
| D,A | US 5 371 498 A (KWON SOON D ET AL) 6 décembre 1994<br>* le document en entier *<br>----- | 1,4 | |

| | DOMAINES TECHNIQUES RECHERCHES (Int.Cl.6) |
|---|---|
| | H03M |

Le présent rapport a été établi pour toutes les revendications

| Lieu de la recherche | Date d'achèvement de la recherche | Examinateur |
|---|---|---|
| LA HAYE | 15 février 1999 | Feuer, F |

EPO FORM 1503 03 82 (P04C02)